# EUROPÄISCHE PATENTSCHRIFT

(11) **EP 0 501 290 B1**
(45) Veröffentlichungstag und Bekanntmachung des Hinweises auf die Patenterteilung: **10.04.1996**
(21) Anmeldenummer: 92102724.9
(22) Anmeldetag: 19.02.1992
(51) Int. Cl.: H05K 13/04, B23K 1/005, H01L 21/68, H01L 21/60

(54) **Einrichtung zum Laserlöten von Mikrokontakten**
Device for laser soldering micro-contacts
Dispositif de brasage de micro-contacts au laser

(30) Priorität: 25.02.1991 DE 4105874
(43) Veröffentlichungstag der Anmeldung: 02.09.1992
(73) Patentinhaber: TEMIC TELEFUNKEN microelectronic GmbH, D-74072 Heilbronn (DE)
(72) Erfinder: Möller, Werner, Dipl.-Chem. Dr., W-7900 Ulm (DE); Ganter, Helmut, Dipl.-Ing., W-7730 VS-Schwenningen (DE); Knödler, Dieter, Dipl.-Ing., W-7339 Eschenbach (DE)
(74) Vertreter: Maute, Hans-Jürgen, Dipl.-Ing.

(56) Entgegenhaltungen:
- US-A- 4 979 290
- 21ST ELECTRONIC COMPONENTS CONFERENCE 12. Mai 1971, WASHINGTON VS Seiten 417 - 425; H.E. HUGHES ET AL.: 'Magnetic Handling of Beam Lead Integrated Circuits'

## Beschreibung

Die Erfindung betrifft eine Einrichtung zum Laserlöten von Mikrokontakten vorbeloteter mikro-elektronischer Bauelemente (Chips), die zusammen mit einem Niederhalter mittels eines Transportschlittens auf einen XY-Tisch befördert und dort gehalten werden.

Durch die Anmelderin - beispielsweise - sind solche Einrichtungen bekannt geworden, wobei auf die Druckschriften DE 36 06 764 A1, DE 37 01 013 C2 und DE 39 39 812 verwiesen wird. Mit diesen Einrichtungen können vorverzinnte Mikroelektronik-Bauelemente mit sehr dünnen, zahlreichen und parallelliegenden Kontakten - sogenannten Leads - und in geringen Abständen nach dem rationellen TAB-Lötverfahren (tape automated bonding) verbunden werden, wobei durch diese Art des Laserlötens von TAB-Kontakten der Vorteil gegeben ist, daß die Lötkoordinaten mit den Positionierungsdaten über ein Programm schnell ausgewechselt werden können und daher das Verfahren gegenüber den bisherigen Stempel-Lötverfahren mit spezifischen Thermoden-Werkzeugen flexibel und ohne große Umrüstzeiten eingesetzt werden. Alle diese bekannten Verfahren und Einrichtungen hierzu weisen jedoch den Nachteil auf, daß sie für Mikroelektronikschaltungen zu groß dimensioniert sind und zu viele spezielle Ausführungsformen für die verschiedenen Bauelementengrößen erfordern. Die Thermoden- bzw. Thermokompressionstechnik erfordert konstante Fließdrücke und -Temperaturen für alle zunehmend zahlreicheren Anschlüsse, die sich z.B. bei über 100 Anschlüssen (bis zu 1000 sind derzeit möglich) beim simultanen Stempelverfahren zu Bruchwerten addieren. Häufig oder kritisch sind Keramikbrüche. Das thermisch und mechanisch schonende und berührungslose sehr vorteilhafte Laserlötverfahren setzt aber voraus, daß alle Anschlüsse plan auf den Bondstellen liegen, was praktisch nicht immer der Fall ist.

Es wurde versucht, laserlichtdurchlässige Glasscheibchen, z.B. Mikroskop-Deckgläschen aufzulegen, was aber bei geringsten Verschmutzungen durch Flußmittel oder Lotverspratzungen sofort zu Lötschwierigkeiten führte. Es folgte das Auflegen und Beschweren der Mikrokontakte mit Metallrahmen, die aber wiederum so planar sein müssen, daß alle Anschlüsse anliegen. Bei den Lotzinnschichten von 10 ±5 µm müßte die Genauigkeit dann bei ≤ 5 µm liegen.

Es ist daher die Aufgabe der Erfindung, eine Vorrichtung zu schaffen, die es beim Laserlöten von Mikrokontakten mit dünnen Lotschichten ermöglichen, alle Bond-Kontakte so an die Leiterbahnen zu schmiegen, daß ein Verschmelzen im Laserstrahl erfolgt, Kontaktverformungen ausgeglichen werden, nahezu druckfrei gebondet wird und keine IC- oder bauteilspezifischen, dimensionsgenauen Vorrichtungen erforderlich werden.

Diese Aufgabe wird durch die im Anspruch 1 aufgezeigten Maßnahmen gelöst. Es ergeben sich leicht maschinell austauschbare, für verschiedene Anschlußlängen passende, pneumatisch oder magnetisch anschmiegbare Teile.

In den Unteransprüchen sind Ausgestaltungen und Weiterbildungen angegeben und in der nachfolgenden Beschreibung ist ein Ausführungsbeispiel erläutert und in den Figuren der Zeichnung skizziert. Es zeigen:
- Fig. 1: ein Schemabild des Greifers mit dem Niederhalter in Arbeitsposition,
- Fig. 2: eine perspektivische Darstellung des Greifers mit den Vakuumkanälen in Chip-Positionierstellung in schematischer Darstellung,
- Fig. 3: eine perspektivische Darstellung des mit einer Vielzahl von Kontakten zu verlötenden Chips mit Niederhalter und Vakuumkanälen,
- Fig. 4: eine perspektivische Darstellung einer Niederhalterhälfte mit polpaariger Anordnung der Stabmagnete und
- Fig. 5: schematisch eine Übersicht über eine erfindungsgemäße Löteinrichtung.

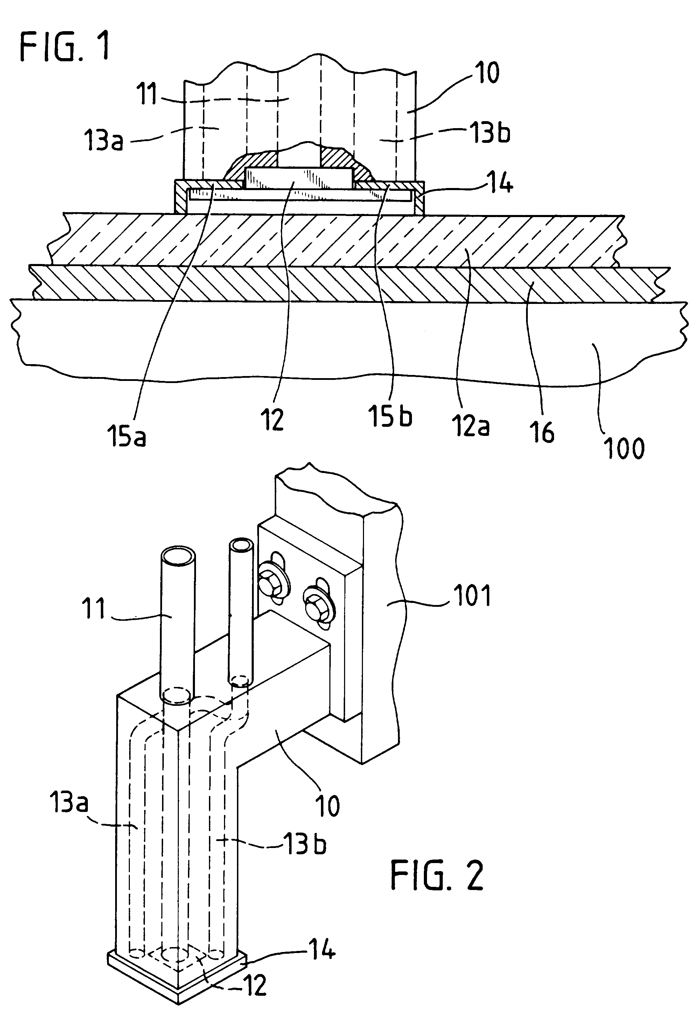

Die Figuren 1 und 2 skizzieren ein Ausführungsbeispiel der genannten Einrichtung zum Laserlöten von Mikrokontakten vorbeloteter mikroelektronischer Chips 12. Hierbei ist dem Transportschlitten 101 ein in Z-Richtung einstellbarer pneumatischer Greifer 10 zugeordnet. Dieser Greifer weist einen zentralen Vakuumkanal 11 für die Entnahme des Chips 12 aus dem Magazin der TAB-Grundanlage mittels der pneumatischen Greifer/Niederhalterkombination 10, 14, ferner für den Chiptransport zur Ablageposition auf dem Substrat 12a und letztlich für die Verlötung auf. Diesem Vakuumkanal 11, der als Zentralkanal angesehen werden kann, sind zwei sogenannte Absaugkanäle 13a und 13b für den rahmenartigen Niederhalter 14 zugeordnet, wobei jedoch diese Kanäle 13a, 13b von dem Zentralkanal 11 unabhängig arbeiten können.

Der Chip 12 in dem Magazin 120 der TAB-Grundanlage wird also von dem Greifer 10 angefahren, der Niederhalter 14 desselben fährt auf dem Chip 12, wird zu diesem exakt positioniert, ergreift ihn und saugt ihn aus dem Magazin, transportiert ihn zum Mikrobauelement bzw. dessen Substrat 12a und positioniert ihn dort mit Hilfe des Visionssystems der Grundanlage oder visuell mit Hilfe eines Mikroskops und einer Drehvorrichtung, worauf dann mittels des Niederhalters 14 der Chip 12 abgelegt, fixiert und dann verlötet wird. Vorher jedoch wird der Vakuumkanal 11 belüftet und der Greifer 10 ohne den Niederhalter 14 hochgefahren.

Der Niederhalter verbleibt auf dem Chip, so daß dieser sicher auf dem Substrat in der Lötposition gehalten wird. Der Niederhalter muß also vom Transportwagen abgekoppelt werden, wenn dieser wie üblich an der Anlage befestigt ist, der XY-Tisch mit dem Chip aber von Anschluß zu Anschluß bewegt werden muß. Der Niederhalter darf sich aber nach dem Abkoppeln bei den Bewegungen und Vibrationen ds XY-Tisches nicht verschieben. Ein Beschwerer reicht bei dünnen Blechrahmen nicht aus. Daher ist ein leichtes Anschmiegen des Blechrahmens pneumatisch oder magnetisch möglich. Um ein konstantes bzw. homogenes magnetisches Feld zu erstellen, müssen die Magnetnadeln entsprechend symmetrisch im Rahmen angeordnet oder in bevorzugter Ausführungsform eine Magnetfolie verwendet werden, die auf den XY-Tisch aufgezogen wird.

Die Magnetfolie kann aber auch bei Kreditkarten-IC's oder Taschenrechner-IC's, d.h., wenn nur ein Bauteil auf eine große Fläche aufgebracht wird, direkt auf einen magnetfilm gezogen werden. Bei Dia-IC-Kassetten, die bei teuren ASICS mehr und mehr gebräuchlich werden, läßt sich der Magnetfilm (oder die Magnete) im Rahmen integrieren.

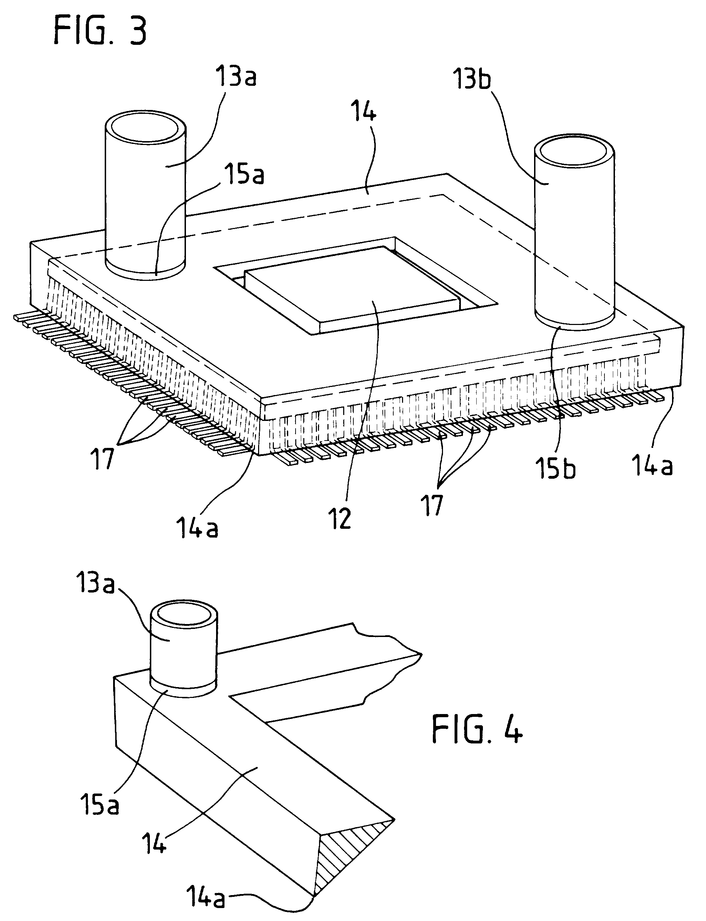

Das Laserlöten der in Figur 3 veranschaulichten vielen Kontaktanschlüsse 17 erfolgt, indem diese Anschlüsse 17 mit Hilfe des PC-programmierten XY-Tisches die Position des Laserfokus durchfahren. Nach der Verlötung wird der Greifer 10 wieder auf den verlöteten Chip bzw. den Niederhalter 14 gefahren, dieser rahmenförmige Niederhalter 14 angesogen und vom Chip abgehoben. Hier muß angeführt werden, daß die Haftung des vielfach verlöteten Chips so gut ist, daß auch eine Mitansaugung des Chips und die Belüftung der zwei Vakuumkanäle 13a und 13b - Vakuumkanal 11 wird jetzt abgeschaltet - diesen in seiner fixierten Position nicht mehr beeinflußt oder gar beschädigt. Ist dies vollzogen, so fährt die Greifer/Niederhalter/Transportschlitten-Einheit zur Fortsetzung bzw. zur Wiederholung des Arbeitsganges in die Magazinierposition für die Entnahme eines neuen Chips 12.

Als vorteilhaft in bezug auf die Raumaufteilung der Greiferkonzeption und die exakte Niederhaltung hat sich gezeigt, wenn die Absaugkanäle 13a, 13b für den Niederhalter 14 in einer Diagonalen des Flächenquerschnitts des Chips 12 in den Greifer 10 und gegebenenfalls in den Rahmen des Niederhalters 14 gebohrt sind.

In einem Ausführungsbeispiel ist vorgesehen, daß der rahmenförmige Niederhalter 14 aus magnetischem Stahl gefertigt und mit je einem Ansaugstutzen 15a, 15b für die Absaugkanäle 13a, 13b versehen ist. Wie bereits erwähnt, arbeiten diese Absaugkanäle unabhängig von dem zentralen Kanal 11, können aber auch gleichzeitig miteinander eingesetzt werden.

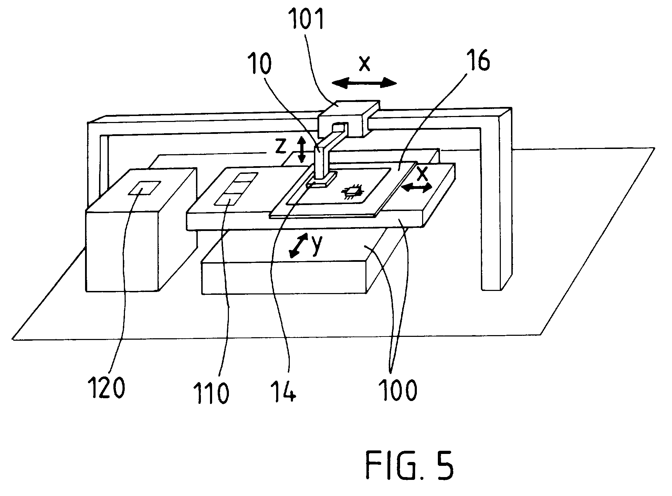

Weiterhin ist vorgesehen, wie in Figur 4 veranschaulicht, daß der Niederhalter 14 mit einer sogenannten "Schneidkante" 14a versehen ist, die entsprechend den über 15 µm großen, zumeist 50 bis 250 µm großen Chipkontakten 17 klein dimensioniert ist, um die Vielzahl dieser Kontakte exakt zur Verlötung niederzuhalten, so daß die zugehörigen Leiterbahnen des Substrats 12a kontaktiert werden und eine Lötung im Laserstrahl einwandfrei erfolgt.

Eine weitere Maßnahme erweist sich als vorteilhaft, und zwar die Zuordnung einer aus Kunststoff mit Magnetpulverfüllung gefertigten Magnetfolie 16, die den XY-Tisch 100 zumindest im Bereich der Bestückungspositionierung und Laserlötung abdeckt und dem magnetischen Stahlrahmen des Niederhalters 14 zugeordnet ist. An den Schneiden des Rahmens können auch vier polpaarig angeordnete Stabmagnete angebracht sein.

Figur 5 zeigt schematisch eine Übersicht über eine erfindungsgemäße Löteinrichtung mit einer Magnetfolie. Dabei ist mit 100 der xy-Tisch bezeichnet, mit 101 der Transportschlitten, auf dem der Greifer 10 mit dem davon abkoppelbaren Niederhalter 14 gelagert ist, sowie mit 16 die Magnetfolie. Ferner ist mit 110 das Wechselmagazin für den Niederhalter 14 und mit 120 das Bauteilmagazin angedeutet.

Der Vorteil der Maßnahmen gemäß der Erfindung ist, daß der Niederhalter 14 nach dem Absetzen auf dem Substrat 12a durch die Magnetkraft zuverlässig in dieser Position bis zum Ende der Verlötung des Chips gehalten wird und exakt positioniert bleibt und das Blech sich geringsten Dimensionsunterschieden der Leiterbahnen/Lötkontakte anpaßt.

## Patentansprüche

1. Einrichtung mit einem rahmenförmigen Niederhalter (14) und einem Transportschlitten (101), bei welcher zum Laserlöten von Mikrokontakten vorbeloteter mikro-elektronischer Bauelemente (12), diese zusammen mit dem Niederhalter mittels des Transportschlittens auf einen XY-Tisch befördert und dort gehalten werden, wobei der Transportschlitten (101) mit einem in Z-Richtung einstellbaren pneumatischen Greifer (10) versehen ist, der einen zentralem Vakuumkanal (11) für den Transport und die Positionierung der Bauelemente (12) aufweist, dem wenigstens ein Absaugkanal (13a, 13b) zum ansaugen und abheben des rahmenförmigen Niederhalters (14) zugeordnet ist, der unabhängig von dem zentralen Vakuumkanal (11) arbeitet.

2. Einrichtung nach Anspruch 1, **dadurch gekennzeichnet,** daß die Absaugkanäle (13a, 13b) im Flächenquerschnittes des Greifers (10) und gegebenenfalls in den Niederhalter (14) gebohrt sind.

3. Einrichtung nach den Ansprüchen 1 oder 2, **dadurch gekennzeichnet,** daß der rahmenförmige Niederhalter (14) aus magnetischem Stahl gefertigt und mit je einem Ansaugstutzen (15a oder 15b) für die Absaugkanäle (13a bzw. 13b) versehen ist.

4. Einrichtung nach den Ansprüchen 1 bis 3, **dadurch gekennzeichnet,** daß dem Niederhalter (14) eine aus Kunststoff mit Magnetpulverfüllung gefertigte Magnetfolie (16) zugeordnet ist, die den XY-Tisch (100) im Bereich der Bestückung und Laserlötung abdeckt.

5. Einrichtung nach den Ansprüchen 1 bis 4, **dadurch gekennzeichnet,** daß der Niederhalter (14) an seiner den zu verlötenden Kontakten (17) zugeordneten Fläche Schneiden aufweist.

6. Einrichtung nach Anspruch 5, **dadurch gekennzeichnet**, daß an den Schneiden (14a) vier entsprechend dimensionierte Stabmagnete (18) polpaarig angeordnet sind.

## Claims

1. Apparatus including a frame-shaped holding-down device (14) and a transport carriage (101) in which, for laser soldering the micro-contacts of micro-electronic components (12) which have been pre-provided with solder, these are conveyed over an XY table together with the holding-down device by means of the transport carriage and are held there, wherein the transport carriage (101) is provided with a pneumaLic gripping means (10) which can be adjusted in the Z direction and which includes a central vacuum channel (11) for the transportation and the positioning of the components (12) and with which there is associated at least one suction channel (13a, 13b) that is used for sucking in and lifting the frame-shaped holding-down device (14) and that functions independently of the central vacuum channel (11).

2. Apparatus in accordance with Claim 1, characterised in that, the suction channels (13a, 13b) are bored in the surface section of the gripping means (10) and, possibly also, in the holding-down device (14).

3. Apparatus in accordance with Claims 1 or 2, characterised in that, the frame-shaped holding-down device (14) is made from magnetic steel and is provided with a suction port (15a or 15b) for each of the respective suction channels (13a and 13b).

4. Apparatus in accordance with Claims 1 to 3, characterised in that, a magnetic foil (16), which is made of a synthetic material including a magnetic powder filling and which covers the XY table (100) in the assembly and laser soldering region, is associatcd with the holding-down device (14).

5. Apparatus in accordance with Claims 1 to 4, characterised in that, the holding-down device (14) comprises cutters on its surface associated with the contacts (17) that are to be soldered.

6. Apparatus in accordance with Claim 5, characterised in that, four appropriately dimensioned bar magnets (18) are arranged as pole pairs on the cutters (14a).

## Revendications

1. Dispositif comprenant un presseur (14) en forme de cadre et un chariot de transport (101), servant au brasage au laser de microcontacts de composants microélectroniques (12) préalablement garnis de brasure, qui sont acheminés ensemble avec le presseur sur une table XY au moyen du chariot de transport et y sont maintenus en place, dans lequel le chariot de transport (101) est pourvu d'un préhenseur pneumatique (10) réglable dans la direction Z et présentant un canal à vide central (11) pour le transport et le placement des composants (12), auquel est conjugué au moins un canal d'aspiration (13a, 13b) pour aspirer et soulever le presseur (14) en forme de cadre, canal d'aspiration qui fonctionne indépendamment du canal à vide central (11).

2. Dispositif selon la revendication 1, caractérisé en ce que les canaux d'aspiration (13a, 13b) sont percés dans l'aire de section du préhenseur (10) et éventuellement dans le presseur (14).

3. Dispositif selon la revendication 1 ou 2, caractérisé en ce que le presseur (14) en forme de cadre est fabriqué en acier magnétique et pourvu d'une tubulure d'aspiration (15a ou 15b) pour chacun des canaux d'aspiration (13a ou 13b).

4. Dispositif selon les revendications 1 à 3, caractérisé en ce qu'une feuille magnétique (16), fabriquée d'une matière plastique avec un remplissage de poudre magnétique, est coordonnée au presseur (14) et recouvre la table XY (100) dans la zone de placement et de brasage au laser.

5. Dispositif selon les revendications 1 à 4, caractérisé en ce que le presseur (14) présente des tranchants sur sa face coordonnée aux contacts (17) à braser.

6. Dispositif selon la revendication 5, caractérisé en ce que quatre aimants en barreau (18), dimensionnés en conséquence, sont disposés sur les tranchants (14a) de manière à former des paires de pôles.
